# FASCICULE DE BREVET EUROPEEN

(11) **EP 2 082 435 B1**
(45) Date de publication et mention de la délivrance du brevet: **10.03.2010**
(21) Numéro de dépôt: 07821674.4
(22) Date de dépôt: 23.10.2007
(51) Int. Cl.: H01L 31/0224, H01L 31/18, H01L 21/00

(54) **DISPOSITIF ET PROCEDE DE METALLISATION**
METALLISIERUNGSEINRICHTUNG UND VERFAHREN
METALLIZING DEVICE AND METHOD

(30) Priorité: 24.10.2006 FR 0654485
(43) Date de publication de la demande: 29.07.2009
(73) Titulaire: COMMISSARIAT A L'ENERGIE ATOMIQUE, 75015 Paris (FR)
(72) Inventeur: BETTINELLI, Armand, 38500 Coublevie (FR)
(74) Mandataire: Ilgart, Jean-Christophe
(86) Numéro de dépôt international: PCT/EP2007/061310
(87) Numéro de publication internationale: WO 2008/049816

(56) Documents cités:
- WO-A-00/44051
- GB-A- 2 352 209
- US-B2- 7 040 523
- H.H.C. DE MOOR ET AL: "Printing high and fine metal lines using stencils" 14TH EUROPEAN PHOTOVOLTAIC SOLAR ENERGY CONFERENCE AND EXHIBITION, BARCELONA 30.06-04.07.1997, 30 avril 1997 (1997-04-30), XP002437735 Barcelona
- J. HOORNSTRA ET AL.: "The importance of paste rheology in improving fine line, thick film screen printing of front" 14TH EUROPEAN PHOTOVOLTAIC SOLAR ENERGY CONFERENCE AND EXHIBITIONS, BARCELONA 30.06.1997, 30 juin 1997 (1997-06-30), XP002437736 Barcelona

## Description

L'invention concerne la métallisation, ou réalisation de contacts métalliques, de dispositifs semi-conducteurs, et plus particulièrement la métallisation de cellules photovoltaïques.

Les cellules photovoltaïques comportent des métallisations réalisées soit sur la face avant, c'est-à-dire la face destinée à recevoir un rayonnement lumineux, et sur la face arrière, soit uniquement sur la face arrière (cellules RCC pour « Rear Contact Cell » ou IBC pour « Interdigitated Back Contact » en anglais). Afin que la cellule reçoive un rayonnement maximal, les métallisations réalisées en face avant sont de préférence étroites pour réduire le plus possible la surface occupée sur la face avant de la cellule, c'est-à-dire minimiser l'ombrage sur cette face avant. Cependant, ces métallisations doivent avoir une section suffisante pour limiter les résistances séries, ce qui impose une épaisseur d'autant plus grande que les conducteurs sont plus étroits et que la résistivité du matériau est forte.

La métallisation par sérigraphie consiste à déposer une quantité significative de pâte, ou encre, sur un écran, de type pochoir ou toile, puis à faire passer la pâte à travers l'écran par des raclages successifs de cette pâte sur l'écran. Seule un faible volume de la pâte de métallisation traverse l'écran à chaque raclage. L'encre n'est forcée à traverser l'écran que dans la zone située sous la racle, cette zone se déplaçant d'un côté à l'autre durant la sérigraphie.

Les pochoirs sont des plaques métalliques dans lesquelles ont été réalisées des ouvertures. Ces pochoirs sont utilisés pour la réalisation de motifs discontinus, notamment pour les dépôts de plots de pâtes à souder sur les circuits imprimés.

Si de longs motifs continus doivent être réalisés, comme c'est le cas pour la réalisation de métallisations de cellules photovoltaïques, on utilise généralement des écrans de type toile, à base de fils tissés généralement en polyester ou en acier, la toile étant étanchéifiée localement par le revêtement d'un film ou d'une émulsion photosensible qui a été ôtée dans les zones du motif à réaliser.

La viscosité de la pâte utilisée doit être adaptée à la géométrie des motifs à réaliser.

Toutes les mesures de viscosité données dans ce document sont réalisées dans les conditions standards suivantes : dispositif de mesure de viscosité de marque Brookfield HBT™, tige de type SC4-14/6R, pour une vitesse de rotation de 10 tr/min, à une température de 25°C, (« Brookfield HBT, SC4-14/6R, @ 10 rpm (25°C) »).

Des pâtes dont la viscosité est relativement faible (de l'ordre de 50 Pa.s) sont utilisées pour la sérigraphie de faces arrières de cellules photovoltaïques, où une grande surface doit être couverte par cette pâte, par exemple à base d'aluminium. Cette faible viscosité permet un décollement aisé de l'écran après l'étalement de cette pâte.

Des pâtes, par exemple à base d'argent, de plus grande viscosité (comprise entre environ 80 Pa.s et 300 Pa.s) sont utilisées pour la sérigraphie de conducteurs étroits sur la face avant de la cellule photovoltaïque.

Cette gamme de viscosité, qui est la seule disponible dans le commerce pour la réalisation de métallisations en face avant de cellules photovoltaïques, a été choisie car elle permet à la pâte de traverser correctement la toile utilisée pour la sérigraphie. De plus, lorsqu'une toile est utilisée pour la sérigraphie, la pâte n'est pas transférée sous les croisements des fils de la toile. Avec une telle viscosité, la pâte transférée dans les ouvertures de maille s'étale pour constituer un motif continu assez régulier. Enfin, cette gamme de viscosité permet également que les pâtes de sérigraphie ne bouchent pas les motifs de l'écran utilisé lors de la sérigraphie.

La sérigraphie est une technique économique du fait de sa forte productivité, mais conduit à un facteur de forme hauteur / largeur limité pour les métallisations. Typiquement, les métallisations réalisées par sérigraphie sur une cellule photovoltaïque ont une largeur comprise entre environ 100 µm à 200 µm et une épaisseur comprise entre environ 10 µm et 20 µm.

Le document US-B-7 040 523 décrit un dispositif de métallisation destiné à métalliser un dispositif semi-conducteur.

Des problèmes liés à l'évaporation des solvants se trouvant dans la pâte de métallisation apparaissent également au cours d'une sérigraphie. Cette évaporation peut faire obstacle à une métallisation correcte du dispositif semi-conducteur. De plus, durant la sérigraphie, la pâte de métallisation est soumise à des mouvements de cisaillement dus au raclage, impliquant une diminution de la viscosité de la pâte et provoquant un étalement intempestif de cette pâte de métallisation.

### EXPOSÉ DE L'INVENTION

Un but de la présente invention est de proposer un dispositif permettant de métalliser un dispositif semi-conducteur en s'affranchissant des problèmes d'évaporation des solvants et d'étalement de la pâte de métallisation rencontrés pendant une sérigraphie.

Pour cela, la présente invention propose un dispositif de métallisation destiné à métalliser un dispositif semi-conducteur, comportant :
- une enceinte fermée de volume variable destinée à contenir une pâte de métallisation,
- un écran de sérigraphie formant une des parois de l'enceinte, destiné à être en contact avec le dispositif semi-conducteur pendant sa métallisation,
- des moyens pour appliquer une pression uniforme sur une paroi étanche mobile de l'enceinte et réduire le volume de l'enceinte,
la réduction de volume de l'enceinte étant destinée à faire traverser de manière uniforme la pâte de métallisation à travers l'écran de sérigraphie.

La paroi étanche mobile de l'enceinte peut être une paroi opposée à la paroi formée par l'écran de sérigraphie.

L'écran de sérigraphie peut former une paroi de l'enceinte solidaire des autres parois de l'enceinte.

Avec un tel dispositif, la pâte de métallisation est placée dans un endroit clos, empêchant l'évaporation des solvants présents dans la pâte pendant la métallisation du dispositif semi-conducteur. D'autre part, grâce à la pression uniforme exercée sur la paroi étanche mobile de l'enceinte lors de la métallisation, la pâte passe à travers la totalité de la surface de l'écran en même temps, métallisant ainsi la totalité du dispositif semi-conducteur simultanément. On assure sur l'ensemble du dispositif semi-conducteur une pression uniforme et sensiblement perpendiculaire au dispositif semi-conducteur, ce qui limite les problèmes de friction locale au niveau du dispositif semi-conducteur rencontrés avec les dispositifs l'art antérieur.

De plus, la viscosité de la pâte de métallisation ne diminue pas car elle ne subit pas une vitesse de cisaillement importante comme dans une sérigraphie classique. Il n'y a donc pas d'étalement intempestif de cette pâte pendant la métallisation du dispositif semi-conducteur.

La présente invention s'applique particulièrement à la métallisation d'une cellule photovoltaïque, par exemple en face avant, mais concerne de manière générale la métallisation de tout type de dispositif semi-conducteur.

L'écran de sérigraphie peut comporter :
- au moins une première couche comprenant une première face destinée à être en contact avec le dispositif semi-conducteur pendant sa métallisation et une seconde face opposée à la première face, et au moins une ouverture débouchante au niveau desdites deux faces de la première couche et formant un motif de métallisation du dispositif semi-conducteur,
- au moins une seconde couche comprenant une première face disposée contre la seconde face de la première couche et une seconde face opposée à sa première face, comprenant au moins une ouverture formée par une pluralité d'orifices et débouchante au niveau desdites deux faces de la seconde couche, le motif formé par l'ouverture de la seconde couche étant inclus dans le motif de métallisation du dispositif semi-conducteur lorsque ces motifs sont superposés l'un dans l'autre.

Ainsi, la première couche peut présenter une ou plusieurs ouvertures dont le motif (par exemple une ligne) forme le motif des métallisations à réaliser. La ou les ouvertures de la seconde couche sont formées par des orifices permettant une injection de la pâte de métallisation dans la ou les ouvertures de la première couche, et permettant à la pâte de métallisation de conserver une stabilité latérale pendant toute l'étape de sérigraphie.

Grâce à cet écran, l'injection de la pâte et le décollement de l'écran peuvent être optimisés en choisissant la forme et la taille des orifices formant la ou les ouvertures de la seconde couche et ainsi faire varier le rapport de surface entre la ou les ouvertures de la seconde couche et la ou les ouvertures de la première couche.

Enfin, grâce à la géométrie de cet écran (zone d'injection uniquement en partie haute), il n'est pas nécessaire de réaliser un nappage de la pâte de métallisation déposée pour obtenir des métallisations électriquement continues. De plus, il est possible de transférer une quantité de pâte de métallisation plus importante que par les procédés de l'art antérieur, formant ainsi des conducteurs moins résistifs.

Avantageusement, l'épaisseur de la première couche, déterminant la hauteur des parties basses des métallisations déposées, peut être supérieure à celle de la seconde couche.

Les dimensions de l'ouverture de la première couche au niveau de la première face peuvent être supérieures aux dimensions de l'ouverture au niveau de la seconde face. Une telle ouverture peut être réalisée par électrodéposition. Cette configuration permet de séparer plus facilement l'écran de la pâte de métallisation après le dépôt de la pâte de métallisation.

Les moyens pour appliquer une pression peuvent être un fluide.

Le dispositif, objet de la présente invention, peut comporter en outre une membrane étanche, et un réservoir solide dans lequel est disposé la membrane étanche et dans lequel sont disposés les moyens pour appliquer une pression.

La présente invention concerne également un procédé de métallisation d'un dispositif semi-conducteur, comportant au moins une étape de dépôt d'une pâte de métallisation sur le dispositif semi-conducteur mise en oeuvre par le dispositif de métallisation, également objet de la présente invention, tel que décrit ci-dessus.

La pâte de métallisation peut avoir une viscosité supérieure ou égale à environ 350 Pa.s, ou de préférence supérieure ou égale à environ 400 Pa.s, ou avantageusement comprise entre environ 400 Pa.s et environ 1200 Pa.s, ou de préférence comprise entre environ 600 Pa.s et environ 1000 Pa.s.

Cette augmentation de la viscosité de la pâte de métallisation par rapport aux pâtes de métallisation utilisées dans les procédés de l'art antérieur peut être obtenue en réduisant la proportion de liants dans la composition de la pâte de métallisation. Cette augmentation de la viscosité peut également être obtenue par l'ajout d'un additif rhéologique, par exemple un agent thixotropique.

L'utilisation d'une telle pâte de métallisation permet, par exemple, la réalisation de conducteurs étroits et hauts, réduisant la surface occupée sur une face avant d'une cellule photovoltaïque par rapport aux conducteurs réalisés selon les procédés de l'art antérieur. Cela conduit donc à une augmentation du rendement de conversion d'une cellule photovoltaïque ainsi métallisée en face avant, du fait d'une augmentation du courant produit par la cellule (moins d'ombrage formé par les métallisations en face avant) et de l'amélioration du facteur de forme (diminution de la résistance série de ces métallisations). De même, la réalisation des métallisations en face arrière d'une cellule photovoltaïque par ce procédé, objet de la présente invention, est particulièrement utile lorsque des contraintes de résistance demandent la réalisation de conducteurs étroits.

En utilisant une pâte de viscosité plus élevée, l'étalement limité de cette pâte après son dépôt permet l'obtention de conducteurs plus étroits et plus épais pour un même volume de pâte transféré.

En utilisant une telle pâte de métallisation, l'épaisseur de la métallisation obtenue après séchage est plus élevée du fait de la réduction de perte de volume liée à l'évaporation du ou des solvants présents dans les liants. De plus, la cuisson de la pâte est facilitée par la réduction de la quantité de résine à brûler (cas des pâtes de l'art antérieur dédiées au procédé de métallisation de cellules photovoltaïques avec cuisson à haute température).

La réduction de la quantité de liants signifie également que la teneur métallique de la pâte est supérieure par rapport à la teneur métallique d'une pâte de composition équivalente mais de plus faible viscosité. Ceci est particulièrement vrai pour les pâtes de l'art antérieur (viscosité comprise entre 80 Pa.s et 300 Pa.s) dédiées aux procédé de métallisation de cellules photovoltaïques avec cuisson à basse température (par exemple 180°C), par exemple pour les cellules comportant des structures à hétérojonctions. Dans ces pâtes de métallisation dites « basse température », la partie organique n'est pas un liant temporaire mais une résine qui, en polymérisant, plaque les particules métalliques les unes sur les autres, la résistivité n'étant donc pas améliorée par des réactions de frittage.

L'utilisation conjointe d'une pâte de forte viscosité et d'un écran double couche tel que décrit précédemment permet, après le dépôt de la pâte de métallisation, de séparer l'écran de la pâte de métallisation sans arracher la pâte malgré sa forte viscosité. Contrairement à un écran de type toile où les fils perpendiculaires les uns aux autres se chevauchent, la zone d'injection de la pâte n'est située qu'en partie haute, donc non recouverte de pâte lors du raclage.

### BRÈVE DESCRIPTION DES DESSINS

La présente invention sera mieux comprise à la lecture de la description d'exemples de réalisation donnés à titre purement indicatif et nullement limitatif en faisant référence aux dessins annexés sur lesquels :
- les figures 1A et 1B représentent un dispositif de métallisation, objet de la présente invention, selon un premier mode de réalisation,
- les figures 2A et 2B représentent un exemple d'écran de sérigraphie utilisé dans un dispositif de métallisation, objet de la présente invention,
- les figures 3A, 3B représentent respectivement un dispositif de métallisation, objet de la présente invention, selon une première et une seconde variante du premier mode de réalisation.
- la figure 4 représente un dispositif de métallisation, objet de la présente invention, selon un second mode de réalisation.

Des parties identiques, similaires ou équivalentes des différentes figures décrites ci-après portent les mêmes références numériques de façon à faciliter le passage d'une figure à l'autre.

Les différentes parties représentées sur les figures ne le sont pas nécessairement selon une échelle uniforme, pour rendre les figures plus lisibles.

Les différentes possibilités (variantes et modes de réalisation) doivent être comprises comme n'étant pas exclusives les unes des autres et peuvent se combiner entre elles.

### EXPOSÉ DÉTAILLÉ DE MODES DE RÉALISATION PARTICULIERS

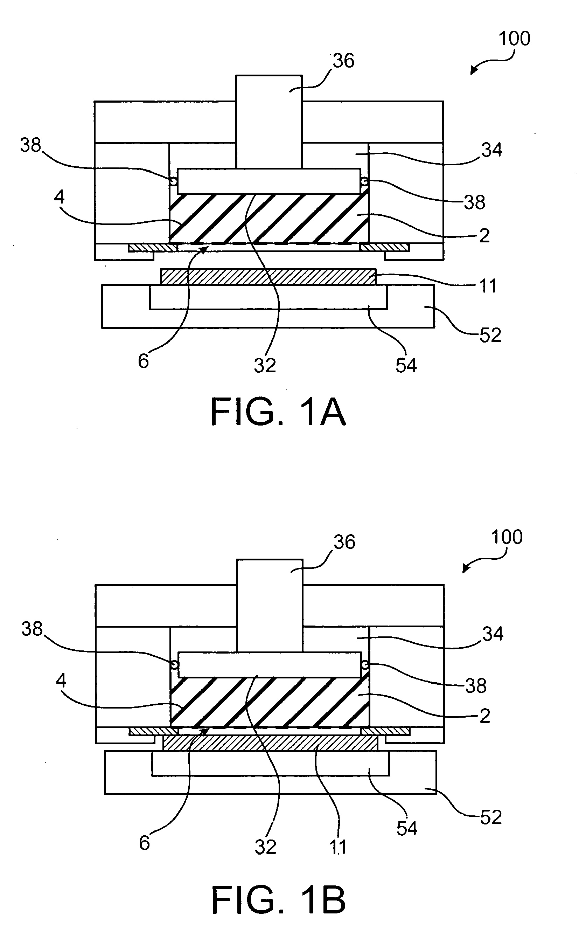

On se réfère tout d'abord à la figure 1A qui représente un dispositif de métallisation 100 selon un premier mode de réalisation.

Le dispositif de métallisation 100 comporte une enceinte fermée 2 de volume variable destinée à contenir de la pâte de métallisation 4. Dans ce premier mode de réalisation, un dispositif semi-conducteur 11 destiné à être métallisé par le dispositif de métallisation 100 est par exemple une cellule photovoltaïque.

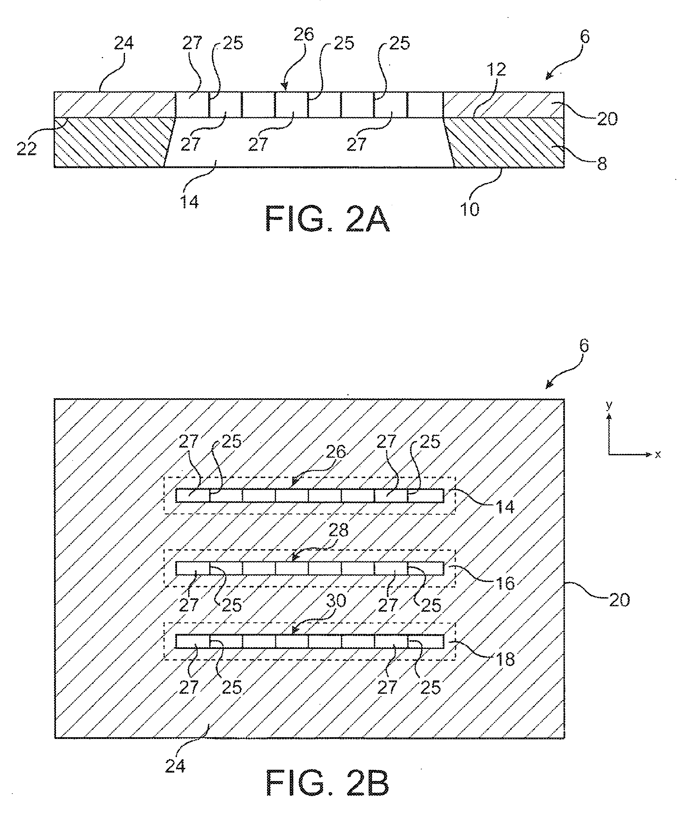

Un écran de sérigraphie 6 forme une des parois de l'enceinte 2. Cet écran de sérigraphie 6 peut par exemple être un écran de type pochoir ou toile. Dans ce premier mode de réalisation, l'écran de sérigraphie 6 est un écran double couche tel que décrit plus loin en liaison avec les figures 2A et 2B.

Dans le dispositif de métallisation 100, l'enceinte fermée 2 est réalisée de sorte que l'application d'une force, ou pression, sur une paroi étanche mobile 32 de l'enceinte 2 opposée à la paroi formée par l'écran de sérigraphie 6 provoque une réduction du volume de l'enceinte 2. Cette réduction de volume de l'enceinte 2 permet de faire traverser de manière uniforme la pâte de métallisation 4 à travers l'écran de sérigraphie 6. Cette pression faisant traverser la pâte de métallisation 4 à travers l'écran 6 est appliquée lorsque l'écran de sérigraphie 6 est en contact avec le dispositif semi-conducteur 11 à métalliser, comme c'est le cas sur la figure 1B.

Dans ce premier mode de réalisation du dispositif de métallisation 100, l'enceinte fermée 2 est formée par un réservoir solide 34 dans lequel coulisse un piston 36, une partie du piston 36 formant la paroi étanche mobile 32 de l'enceinte 2 opposée à la paroi formée par l'écran de sérigraphie 6. Un joint d'étanchéité 38 placé en périphérie du piston 36 coopère avec ce dernier pour former la paroi étanche mobile 32. Dans une variante, une plaquette, par exemple en élastomère, aurait pu être insérée entre le piston 36 et la pâte de métallisation 4 en remplacement du joint 38 pour assurer l'étanchéité de la paroi mobile 32.

Lorsque le dispositif 100 n'est pas en train de métalliser le dispositif semi-conducteur 11, une légère pression est appliquée au piston 36 afin que la pâte de métallisation 4 reste très légèrement comprimée sans dépasser le seuil d'écoulement, c'est-à-dire sans qu'elle traverse l'écran de sérigraphie 6.

Les figures 2A et 2B représentent respectivement une vue en coupe et une vue de dessus d'un exemple de réalisation d'un écran de sérigraphie 6 du dispositif de métallisation 100. On voit sur la figure 2A que cet écran 6 comporte une première couche 8. Une première face 10 est destinée à être en contact, durant l'étape de sérigraphie, avec le dispositif semi-conducteur 11 devant être métallisé. Cette première couche 8 comporte également une seconde face 12 opposée à la première face 10. L'écran de sérigraphie 6 comporte trois ouvertures 14, 16, 18, débouchantes au niveau des deux faces 10, 12 de la première couche 8, formées dans la première couche 8. Sur la figure 2A, seule l'ouverture 14 est représentée. Sur l'exemple des figures 2A et 2B, l'ouverture 14 est une fente, de section trapézoïdale, mais toute autre géométrie est envisageable.

Ainsi, cette ouverture 14 forme un motif de métallisation du dispositif semi-conducteur 11, par exemple pour la réalisation de bus de métallisation de cellule photovoltaïque. Dans cet exemple, les dimensions de l'ouverture 14 au niveau de la première face 10 sont supérieures aux dimensions de l'ouverture 14 au niveau de la seconde face 12, réalisant une métallisation comportant une base plus large que le reste de la métallisation.

L'écran 6 comporte une seconde couche 20 comprenant une première face 22 disposée contre la seconde face 12 de la première couche 8 et une seconde face 24 opposée à sa première face 22. Comme représenté sur la figure 2A, les deux couches 8 et 20 sont disposées l'une contre l'autre. Cette seconde couche 20 comprend trois ouvertures 26, 28, 30, chacune formée par une pluralité d'orifices 27, et débouchante au niveau des deux faces 22, 24 de la seconde couche 20. En superposant les couches 8 et 20, le motif formé par chacune des ouvertures 26, 28, 30 est inclus dans le motif de métallisation, c'est-à-dire le motif formé par chacune des ouvertures 14, 16, 18. Dans l'exemple des figures 2A et 2B, les orifices 27 formant chaque ouverture 26, 28, 30 sont aussi grands que possible et limités par des portions de matière 25 assurant le maintien de la géométrie de la couche 10. Sur les figures 1 et 2, les orifices 27 ont par exemple une dimension selon l'axe x (représenté sur la figure 2B) environ égale à 50 µm. Cette dimension peut également être comprise entre environ 50 µm et 200 µm. Sur la figure 2B, on voit que les orifices 27 sont de forme rectangulaire et disposés en ligne.

Dans cet exemple de réalisation, la première couche 8 a une épaisseur supérieure à celle de la seconde couche 20, mais les deux couches 8, 20 pourraient également avoir une épaisseur sensiblement identique. Dans un autre exemple de réalisation, la première couche 8 pourrait également avoir une épaisseur inférieure à celle de la seconde couche 20.

La pâte de métallisation 4 utilisée par le dispositif de métallisation 100 peut, par exemple, avoir une viscosité supérieure ou égale à environ 350 Pa.s.

Une pâte de métallisation de viscosité supérieure ou égale à environ 350 Pa.s peut être obtenue en mélangeant diverses matières premières. Ces matières premières sont par exemple :
- un solvant à haute température d'ébullition (par exemple 219°C), limitant ainsi son évaporation, tel que du terpinéol,
- une résine de très faible viscosité, telle que de l'ethyl-cellulose à faible grade de viscosité, par exemple N4 (Hercules),
- des poudres d'argent fines sphériques dont le diamètre peut être de taille moyenne, par exemple de l'ordre d'un µm, ou des paillettes de taille inférieure à environ 10 µm, ou un mélange des deux,
- de la fritte de verre dans des proportions similaires à celles utilisées pour les pâtes de métallisation de l'art antérieur.

Un empâtage de ces matières premières est ensuite réalisé en dispersant ces particules de matières premières dans le liant. Pour cela, on peut réaliser un malaxage d'abord lent pour mouiller les particules, puis plus rapide pour en améliorer la dispersion. Ce malaxage peut se faire par exemple avec un malaxeur de type papillon. Un raffinage, en utilisant par exemple un tricylindre ou un mélangeur sans contact associant rotation et révolution, par exemple du type VMX-N360 de EME™, permet ensuite d'obtenir la pâte de métallisation utilisée dans le procédé de métallisation décrit précédemment. D'autres méthodes pour augmenter la viscosité de la pâte sont possibles, par exemple en ajoutant un agent thixotropique.

Des pâtes de métallisation de viscosité supérieure ou égale à 350 Pa.s peuvent aussi être obtenues en « rechargeant » des pâtes commerciales de viscosité comprise entre environ 80 Pa.s et 300 Pa.s, c'est-à-dire en rajoutant des matériaux à ces pâtes. Le matériau de recharge peut par exemple être des particules métalliques ou un mélange de particules métalliques et de fritte de verre, des particules ayant une finesse suffisante pour permettre la réalisation de fines métallisations, ou encore de la fritte de verre de préférence prédispersée dans de l'argent. Des poudres d'argent, par exemple similaires à celles décrites précédemment, peuvent également être utilisées pour le rechargement des pâtes commerciales. L'empâtage et le raffinage réalisés après l'ajout de ces matériaux sont, comme décrit précédemment, adaptés aux fortes viscosités des pâtes obtenues.

Pour réaliser la métallisation du dispositif semi-conducteur 11, on dispose tout d'abord le dispositif 11 à métalliser face à l'écran de sérigraphie 6, sur un support 52, par exemple en métal ou en élastomère dur (par exemple d'une dureté supérieure à environ 90 Shores). De manière avantageuse, le dispositif 11 peut être aligné mécaniquement et/ou optiquement avec l'écran de sérigraphie 6. Le dispositif de métallisation 100 peut comporter par exemple, dans ce premier mode de réalisation, des moyens de refroidissement 54 intégrés au support 52 recevant le dispositif à métalliser 11. Ces moyens de refroidissement permettront de « figer » la pâte de métallisation 4 déposée sur le dispositif 11 en augmentant brutalement sa viscosité. Ces moyens de refroidissement sont avantageusement utilisés lorsque la pâte de métallisation 4 est chauffée dans l'enceinte 2 pour faciliter son extraction comme cela est décrit plus loin dans la description.

Le dispositif semi-conducteur 11 à métalliser et l'écran de sérigraphie 6 sont ensuite amenés en contact l'un contre l'autre, comme représenté sur la figure 1B. Dans ce premier mode de réalisation, c'est la partie supérieure du dispositif de métallisation 100 comportant l'enceinte fermée 2 et le piston 36 qui est déplacée vers le dispositif semi-conducteur 11.

Le piston 36 applique ensuite une pression sur la pâte de métallisation 4, réduisant ainsi le volume de l'enceinte 2 et transférant de la pâte de métallisation 4 sur le dispositif semi-conducteur 11 à travers l'écran de sérigraphie 6. La pression à appliquer est d'autant plus grande que la surface des ouvertures formées dans l'écran de sérigraphie 6 est grande et que la viscosité de la pâte est élevée. La réduction de volume de l'enceinte 2 est très faible et correspond au volume de la pâte de métallisation 4 transféré dans les ouvertures 14, 16, 18, 26, 28 et 30 de l'écran de sérigraphie 6.

Une fois la pâte de métallisation 4 déposée sur le dispositif semi-conducteur 11, l'écran de sérigraphie 6 est ensuite séparé du dispositif semi-conducteur 11 en remontant la partie supérieure (piston 36 et enceinte fermée 2) du dispositif de métallisation 100. Cette séparation est facilitée par la structure double couche de l'écran 6 et du fait que la pâte de métallisation utilisée contient moins de liant que les pâtes de métallisation standards. Même si la pâte de métallisation 4 a une forte viscosité ( > 350 Pa.s), la structure double couche de l'écran 6 permet de le retirer sans risquer d'arracher la pâte de métallisation déposée. De plus, l'élasticité du support 52 en élastomère dur favorise la séparation écran /pâte de métallisation sans dégât.

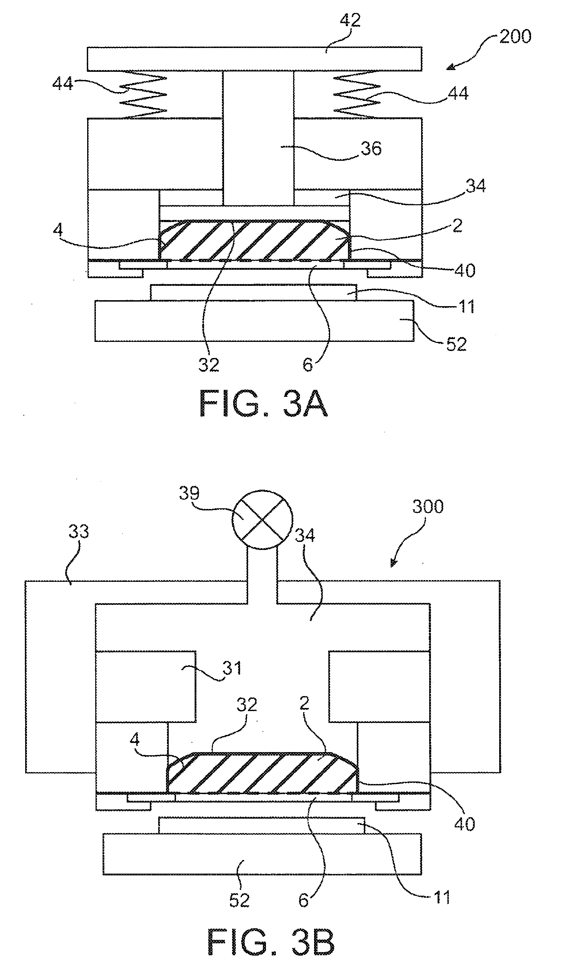

La figure 3A représente un dispositif de métallisation 200 selon une première variante du premier mode de réalisation. Dans cette première variante, l'étanchéité de la paroi 32 n'est pas assurée par un joint d'étanchéité mais par une membrane étanche 40, par exemple à base d'élastomère, formant à elle seule la paroi étanche 32. Par rapport au premier mode de réalisation, ce n'est pas le réservoir solide 34 qui forme l'enceinte 2, mais la membrane étanche 40 qui est disposée dans le réservoir solide 34.

Dans cette première variante du premier mode de réalisation, la pression est appliquée sur un élément 42 relié au piston 36. Cette pression fait tout d'abord descendre la partie supérieure du dispositif 200, formée par l'enceinte fermée 2 et le piston 36, jusqu'à ce que l'écran de sérigraphie 6 soit en contact avec le dispositif semi-conducteur 11. La pression appliquée au piston 36 pousse alors la pâte de métallisation 4 à travers l'écran de sérigraphie 6. Lorsque le dispositif 200 est au repos, c'est-à-dire lorsqu'il n'est pas en train d'injecter de la pâte de métallisation sur le dispositif semi-conducteur à métalliser 11, des ressorts 44, réglés pour être actifs en traction, servent à pressuriser l'enceinte 2 légèrement en dessous du seuil d'écoulement de la pâte de métallisation afin que celle-ci ne s'écoule pas.

La figure 3B représente un dispositif de métallisation 300 selon une seconde variante du premier mode de réalisation. Par rapport au dispositif 200 de la figure 3A, la pression n'est pas appliquée par un piston 36, mais directement par un fluide injecté dans le réservoir solide 34 par une pompe 39. Lorsque le dispositif 300 est au repos, c'est-à-dire lorsqu'il n'est pas en train d'injecter de la pâte de métallisation 4 sur le dispositif semi-conducteur à métalliser 11, le fluide exerce une légère pression, dans l'enceinte 2 afin que la pâte de métallisation 4 soit en légère compression, mais reste sous son seuil d'écoulement. Pour déposer la pâte de métallisation 4 sur le dispositif semi-conducteur 11, on applique une plus forte pression par l'intermédiaire du fluide sur une partie 31 du dispositif 300 mobile par rapport à une partie fixe 33 du dispositif 300. La partie mobile 31 descend jusqu'à ce que l'écran de sérigraphie 6 soit en contact avec le dispositif semi-conducteur 11. Ensuite, la pression appliquée par le fluide s'exerce sur la membrane 40, poussant alors la pâte de métallisation 4 à travers l'écran de sérigraphie 6 sur le dispositif semi-conducteur 11.

Cette variante de réalisation présente l'avantage d'exercer une pression uniforme sur toute la surface de la membrane 40.

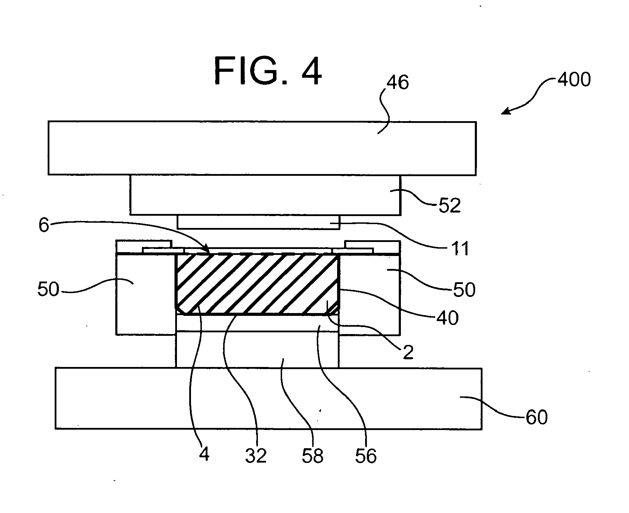

La figure 4 représente un dispositif de métallisation 400 selon un second mode de réalisation. Ce dispositif 400 comporte une partie supérieure formée par un plateau 46, lié à un support 52 destiné à recevoir le dispositif semi-conducteur 11.

Le dispositif de métallisation 400 comporte une partie inférieure comportant un réservoir solide formé par des parois latérales 50 et un élément 58 formant une paroi de fond, les parois latérales 50 étant mobiles en translation par rapport à l'élément 58. Une enceinte fermée 2 formée par une membrane étanche 40 est disposée dans le réservoir solide. Un plateau 60 supporte les éléments de la partie inférieure du dispositif de métallisation 400. Des moyens de régulation 56, tels qu'une plaque à base d'un matériau conducteur thermique comportant un réseau de tubulures intégré permettant la circulation d'un fluide régulé en température, permettent de contrôler la température à l'intérieur de l'enceinte 2 et de la réguler afin, par exemple, de diminuer temporairement la viscosité de la pâte pour faciliter l'injection en amenant la pâte à une température supérieure à la température ambiante, par exemple à environ 35°C.

Pour réaliser la métallisation du dispositif semi-conducteur 11, une pression est appliquée sur le plateau 46, faisant descendre la partie supérieure du dispositif de métallisation 400 jusqu'à ce que l'écran de sérigraphie 6 soit en contact avec le dispositif à métalliser 11. En continuant d'appliquer une pression sur le plateau 46, cette pression est transmise aux parois latérales 50, les faisant descendre par rapport aux éléments 56, 58, réduisant ainsi le volume de l'enceinte fermée 2 et faisant traverser la pâte de métallisation 4 à travers l'écran de sérigraphie 6.

Une fois la pâte de métallisation 4 déposée sur le dispositif semi-conducteur 11, l'écran de sérigraphie 6 est ensuite séparé du dispositif semi-conducteur 11 en remontant la partie supérieure (plateau 46, support 52 et dispositif semi-conducteur 11) du dispositif de métallisation 400.

Dans une variante de ce second mode de réalisation, la pression peut être appliquée sur le plateau 60, faisant déplacer la partie inférieure (plateau 60, parois 50, éléments 56, 58 et réservoir solide) du dispositif de métallisation 400 vers le haut. Lorsque l'écran de sérigraphie 6 est en contact avec le dispositif 11 à métalliser, la pression appliquée au plateau 60 entraîne une translation des éléments 56, 58 par rapport aux parois latérales 50, réduisant ainsi le volume de l'enceinte 2 et réalisant la métallisation du dispositif semi-conducteur 11.

Avec un tel dispositif de métallisation, combiné par exemple avec un écran de sérigraphie double couche et une pâte de métallisation de viscosité supérieure à environ 350 Pa.s, par exemple comprise entre environ 800 Pa.s et 900 Pa.s, il est possible d'obtenir des métallisations dont le facteur de forme est élevé, par exemple de l'ordre de 0,5 pour une pâte de métallisation de viscosité égale à environ 900 Pa.s, idéal pour des conducteurs étroits de cellules photovoltaïques (par exemple, conducteurs étroits de largeur égale à environ 80 µm et d'épaisseur égale à environ 40 µm).

Un tel dispositif de métallisation peut être placé dans la tête d'une machine de sérigraphie, en remplacement de l'ensemble porte écran et racle utilisé pendant une sérigraphie classique. Cette tête est suffisamment robuste pour appliquer une pression suffisante pour que, quelle que soit la viscosité de la pâte de métallisation utilisée, la pâte puisse être injectée correctement. Le dispositif de métallisation peut être par exemple placé dans une presse, par exemple similaire à une presse d'emboutissage, apportant ainsi une pression suffisante pour la réalisation de métallisations et étant bien adaptée à une forte productivité.

## Revendications

1. Dispositif de métallisation (100, 200, 300, 400) destiné à métalliser un dispositif semi-conducteur (11), comportant :
- une enceinte fermée (2) de volume variable destinée à contenir une pâte de métallisation (4),
- un écran de sérigraphie (6) formant une paroi de l'enceinte (2) solidaire des autres parois de l'enceinte (2), destiné à être en contact avec le dispositif semi-conducteur (11) pendant sa métallisation,
- des moyens (36, 58) pour appliquer une pression uniforme sur une paroi étanche mobile (32) de l'enceinte (2) et réduire le volume de l'enceinte (2),
la réduction de volume de l'enceinte (2) étant destinée à faire traverser de manière uniforme la pâte de métallisation (4) à travers l'écran de sérigraphie (6).

2. Dispositif (100, 200, 300, 400) selon la revendication 1, la paroi étanche mobile (32) étant une paroi opposée à la paroi formée par l'écran de sérigraphie (6).

3. Dispositif (100, 200, 300, 400) selon l'une des revendications 1 ou 2, l'écran de sérigraphie (6) comportant :
- au moins une première couche (8) comprenant une première face (10) destinée à être en contact avec le dispositif semi-conducteur (11) pendant sa métallisation et une seconde face (12) opposée à la première face (10), et au moins une ouverture (14, 16, 18) débouchante au niveau desdites deux faces (10, 12) de la première couche (8) et formant un motif de métallisation du dispositif semi-conducteur (11),
- au moins une seconde couche (20) comprenant une première face (22) disposée contre la seconde face (12) de la première couche (8) et une seconde face (24) opposée à sa première face (22), comprenant au moins une ouverture (26, 28, 30) formée par une pluralité d'orifices (27) et débouchante au niveau desdites deux faces (22, 24) de la seconde couche (20), le motif formé par l'ouverture (26, 28, 30) de la seconde couche (20) étant inclus dans le motif de métallisation du dispositif semi-conducteur (11) lorsque ces motifs sont superposés l'un dans l'autre.

4. Dispositif (100, 200, 300, 400) selon la revendication 3, l'épaisseur de la première couche (2) étant supérieure à l'épaisseur de la seconde couche (14).

5. Dispositif (100, 200, 300, 400) selon l'une des revendications 3 ou 4, les orifices (27) de l'ouverture (20, 22, 24) de la seconde couche (14) étant de forme rectangulaire et disposés en ligne.

6. Dispositif (100, 200, 300, 400) selon l'une des revendications 3 à 5, les dimensions de l'ouverture (8, 10, 12) de la première couche (2) au niveau de la première face (4) étant supérieures aux dimensions de l'ouverture (8, 10, 12) au niveau de la seconde face (6).

7. Dispositif (100, 200, 300, 400) selon l'une des revendications précédentes, comportant en outre un support (52) destiné à supporter le dispositif semi-conducteur (11) pendant sa métallisation.

8. Dispositif (100) selon l'une des revendications précédentes, des moyens de refroidissement (54) destinés à refroidir le dispositif semi-conducteur (11) étant intégrés au support (52).

9. Dispositif (300) selon l'une des revendications précédentes, les moyens pour appliquer une pression étant un fluide.

10. Dispositif (100, 200) selon l'une des revendications 1 à 8, les moyens pour appliquer une pression étant un piston (36).

11. Dispositif (100) selon la revendication 10, un joint d'étanchéité coopérant avec le piston (36) pour former la paroi étanche mobile (32) de l'enceinte (2).

12. Dispositif (100) selon l'une des revendications 10 ou 11, les parois autres que la paroi étanche mobile (32) de l'enceinte (2) étant formées par un réservoir solide (34) dans lequel coulisse le piston (36).

13. Dispositif (200, 300, 400) selon l'une des revendications 1 à 10, comportant en outre une membrane étanche (40) formant l'enceinte (2).

14. Dispositif (200, 300, 400) selon la revendication 13, comportant en outre un réservoir solide (34) dans lequel est disposé la membrane étanche (40) et dans lequel sont disposés les moyens pour appliquer une pression (36, 58).

15. Dispositif (400) selon l'une des revendications précédentes, comportant en outre des moyens de régulation (56) de température de l'enceinte (2).

16. Procédé de métallisation d'un dispositif semi-conducteur (11), comportant au moins une étape de dépôt d'une pâte de métallisation (4) sur le dispositif semi-conducteur (11) mise en oeuvre par le dispositif de métallisation (100, 200, 300, 400) selon l'une des revendications 1 à 15.

17. Procédé selon la revendication 16, la pâte de métallisation ayant une viscosité supérieure ou égale à environ 350 Pa.s.

18. Procédé selon l'une des revendications 16 ou 17, le dispositif semi-conducteur (11) étant une cellule photovoltaïque.

## Claims

1. A metallization device (100, 200, 300, 400) intended to metallize a semiconductor device (11), including:
- a closed enclosure (2) of variable volume intended to contain a metallization paste (4),
- a screen for screen printing (6) forming a wall of the enclosure (2) integral with the other walls of the enclosure (2), intended to be in contact with the semiconductor device (11) during its metallization,
- means (36, 58) for applying uniform pressure over a mobile sealed wall (32) of the enclosure (2) and for reducing the volume of the enclosure (2),
the volume reduction of the enclosure (2) being intended to cause the metallization paste (4) to uniformly pass through the printing screen (6).

2. The device (100, 200, 300, 400) according to claim 1, the mobile sealed wall (32) being a wall opposite to the wall formed by the printing screen (6).

3. The device (100, 200, 300, 400) according to any of claims 1 to 2, the printing screen (6) including:
- at least one first layer (8) comprising a first side (10) intended to be in contact with the semiconductor device (11) during its metallization and a second side (12) opposite to the first side (10), and at least one aperture (14, 16, 18) opening out at said two sides (10, 12) of the first layer (8) and forming a metallization pattern of the semiconductor device (11),
- at least one second layer (20) comprising a first side (22) positioned against the second side (12) of the first layer (8) and a second side (24) opposite to its first side (22), comprising at least one aperture (26, 28, 30) formed by a plurality of orifices (27) and opening out at said two sides (22, 24) of the second layer (20), the pattern formed by the aperture (26, 28, 30) of the second layer (20) being included in the metallization pattern of the semiconductor device (11) when these patterns are superposed into each other.

4. The device (100, 200, 300, 400) according to claim 3, the thickness of the first layer (2) being larger than the thickness of the second layer (14).

5. The device (100, 200, 300, 400) according to any of claims 3 or 4, the orifices (27) of the aperture (20, 22, 24) of the second layer (14) being of rectangular shape and positioned in line.

6. The device (100, 200, 300, 400) according to any of claims 3 to 5, the dimensions of the aperture (8, 10, 12) of the first layer (2) at the first side (4) being larger than the dimensions of the aperture (8, 10, 12) at the second side (6).

7. The device (100, 200, 300, 400) according to any of the preceding claims, further including a support (52) intended to support the semiconductor device (11) during its metallization.

8. The device (100) according to any of the preceding claims, cooling means (54) intended for cooling the semiconductor device (11) being integrated to the support (52).

9. The device (300) according to any of the preceding claims, the means for applying pressure being a fluid.

10. The device (100, 200) according to any of claims 1 to 8, the means for applying pressure being a piston (36).

11. The device (100) according to claim 10, a seal gasket cooperating with the piston (36) in order to form the mobile sealed wall (32) of the enclosure (2).

12. The device (100) according to any of claims 10 or 11, the walls other than the mobile sealed wall (32) of the enclosure (2) being formed by a solid reservoir (34) wherein the piston (36) slides.

13. The device (200, 300, 400) according to any of claims 1 to 10, further including a sealed membrane (40) forming the enclosure (2).

14. The device (200, 300, 400) according to claim 13, further including a solid reservoir (34) wherein the sealed membrane (40) is positioned and wherein the means for applying pressure (36, 58) are positioned.

15. The device (400) according to any of the preceding claims, further including means (56) for regulating the temperature of the enclosure (2).

16. A method for metallizing a semiconductor device (11), including at least one step for depositing a metallization paste (4) on the semiconductor device (11) applied by the metallization device (100, 200, 300, 400) according to any of claims 1 to 15.

17. The method according to claim 16, the metallization paste having a viscosity larger than or equal to about 350 Pa.s.

18. The method according to any of claims 16 or 17, the semiconductor device (11) being a photovoltaic cell.

## Patentansprüche

1. Metallisierungseinrichtung (100, 200, 300, 400), bestimmt zum Metallisierten einer Halbleitervorrichtung (11), umfassend:
- einen geschlossenen Raum (2) mit variablem Volumen, der eine Metallisierungspaste (4) enthält,
- einen eine Wand des Raums (2) bildenden Siebdruckschirm (6), fest verbunden ist mit den anderen Wänden des Raums (2), der mit der Halbleitervorrichtung (11) Kontakt hat während ihrer Metallisierung,
- Mittel (36, 58) zum Anwenden eines gleichmäßige Drucks auf eine bewegliche dichte Wand (32) des Raums (2) und zum Reduzieren des Volumens des Raums (2),
wobei das Reduzieren des Volumens des Raums (2) dazu bestimmt ist, zu bewirken, dass die Metallisierungspaste (4) den Siebdruckschirm (6) gleichmäßig durchquert.

2. Einrichtung (100, 200, 300, 400) nach Anspruch 1, wobei die bewegliche dichte Wand (32) eine der durch den Siebdruckschirm (6) gebildeten Wand entgegengesetzte Wand ist.

3. Einrichtung (100, 200, 300, 400) nach einem der Ansprüche 1 oder 2, wobei der Siebdruckschirm (6) umfasst:
- wenigstens eine erste Schicht (8) mit einer ersten Seite (10), bestimmt für den Kontakt mit der Halbleitervorrichtung (11) während ihrer Metallisierung, und einer der ersten Seite (10) entgegengesetzten zweiten Seite (12) und wenigstens einer Öffnung (14, 16, 18), die auf beiden Seiten (10, 12) der ersten Schicht (8) mündet und ein Metallisierungsmuster des Halbleitervorrichtung (11) bildet,
- wenigstens eine zweite Schicht (20) mit einer an der zweiten Seite (12) der ersten Schicht (8) anliegenden ersten Seite (22) und einer ihrer ersten Seite (22) entgegengesetzten zweiten Seite (24) mit wenigstens einer Öffnung (26, 28, 30), gebildet durch eine Vielzahl von Löcher (27), mündend auf den beiden Seiten (22, 24) der zweiten Schicht (20), wobei das durch die Öffnung (26, 28, 30) gebildete Muster der zweiten Schicht (20) in das Metallisierungsmuster der Halbleitervorrichtung (11) eingeschlossen ist, wenn diese Muster einander überlagert sind.

4. Einrichtung (100, 200, 300, 400) nach Anspruch 3, wobei die Dicke der ersten Schicht (2) größer ist als die Dicke der zweiten Schicht (14).

5. Einrichtung (100, 200, 300, 400) nach einem der Ansprüche 3 oder 4, wobei die Löcher (27) der Öffnung (20, 22, 24) der zweiten Schicht (14) rechteckig sind und reihenförmig angeordnet.

6. Einrichtung (100, 200, 300, 400) nach einem der Ansprüche 3 bis 5, wobei die Dimensionen der Öffnung (8, 10, 12) der ersten Schicht (2) auf der ersten Seite (4) größer sind als die Dimensionen der Öffnung (8, 10, 12) auf der zweiten Seite (6).

7. Einrichtung (100, 200, 300, 400) nach einem der vorangehenden Ansprüche, mit außerdem einem Träger (52), bestimmt zu Unterstützung der Halbleitervorrichtung (11) während ihrer Metallisierung.

8. Einrichtung (100) nach einem der vorangehenden Ansprüche, wobei in dem Träger (52) Mittel zum Abkühlen (54) der Halbleitervorrichtung (11) vorgesehen sind.

9. Einrichtung (300) nach einem der vorangehenden Ansprüche, wobei das Mittel zur Anwendung eines Drucks ein Fluid ist.

10. Einrichtung (100, 200) nach einem der Ansprüche 1 bis 8, wobei das Mittel zur Anwendung eines Drucks ein Kolben (36) ist.

11. Einrichtung (100) nach Anspruch 10, wobei eine Ringdichtung mit dem Kolben (36) kooperiert, um die bewegliche dichte Wand (32) des Raums (2) zu bilden.

12. Einrichtung (100) nach einem der Ansprüche 10 oder 11, wobei die Wände des Raums (2) mit Ausnahme der beweglichen dichten Wand (32) durch einen Behälter (34) in Form eines festen Körpers gebildet werden, in dem der Kolben (36) gleitet.

13. Einrichtung (200, 300, 400) nach einem der Ansprüche 1 bis 10 mit außerdem einer den Raum (2) bildenden dichten Membran (40).

14. Einrichtung (200, 300, 400) nach Anspruch 13 mit außerdem einem Behälter (34) in Form eines festen Körpers, in dem eine Membran (40) angeordnet ist und in dem die Mittel (36, 58) zur Anwendung eines Drucks angeordnet sind.

15. Einrichtung (400) nach einem der vorangehenden Ansprüche mit außerdem Regulierungsmitteln (56) der Temperatur des Raums (2).

16. Verfahren zur Metallisierung einer Halbleitervorrichtung (11), das wenigstens einen Schritt zum Aufbringen einer Metallisierungspaste (4) auf die Halbleitervorrichtung (11) umfasst und durch die Metallisierungseinrichtung (100, 200, 300, 400) nach einem der Ansprüche 1 bis 15 angewendet wird.

17. Verfahren nach Anspruch 16, wobei die Metailisierungspaste eine Viskosität größer oder gleich ungefähr 350 Pa.s. hat.

18. Verfahren nach einem der Ansprüche 16 oder 17, wobei die Halbleitervorrichtung (11) eine Photovoltaikzelle ist.
